# EUROPEAN PATENT SPECIFICATION

(11) **EP 0 677 985 B1**
(45) Date of publication and mention of the grant of the patent: **26.05.1999**
(21) Application number: 94105764.8
(22) Date of filing: 14.04.1994
(51) Int. Cl.: H05K 3/04, H05K 3/10

(54) **Method of manufacturing printed circuit boards**
Verfahren zur Herstellung von Leiterplatten
Procédé pour la fabrication de panneaux à circuit imprimé

(43) Date of publication of application: 18.10.1995
(73) Proprietor: Hewlett-Packard GmbH, D-71034 Böblingen (DE)
(72) Inventor: Tamm, Wilhelm, D-71134 Aidlingen (DE); Dippon, Siegfried, D-75391 Gechingen (DE); Olbrich, Walter, D-71229 Leonberg (DE); Weitmann, Michael, D-71088 Holzgerlingen (DE); Lam, Si-Ty, Pleasanton, CA 94588 (US)
(74) Representative: Harbach, Thomas

(56) References cited:
- FR-A- 2 394 228
- US-A- 4 651 417
- RESEARCH DISCLOSURE, no.340, August 1992, HAVANT GB page 592, XP000328046 34007: 'Circuit fabrication process'
- RESEARCH DISCLOSURE, no.312, April 1990, HAVANT GB page 338, XP000104661 31267: 'Laser preparation of epoxy glass composites for electrolytic metal deposition'
- RESEARCH DISCLOSURE, no.326, June 1991, HAVANT GB page 421, XP000206595 32646: 'PWB made by laser ablation of a plastic covered substrate'
- SYNTHETIC METALS, 1993 pages 3643 - 3648 R. BAUMANN ET AL. 'Local electrical conductivity in poly(bis-alkylthio-acetylene) layers after laser irradiation'

## Description

The invention relates to a method of manufacturing printed circuit boards wherein metallic conductor structures according to a desired pattern and holes are produced in a substrate of isolating material. In particular, the invention relates to such a method using laser ablation.

### BACKGROUND OF THE INVENTION

Known methods for manufacturing printed circuit boards use photolithographic techniques to produce the desired pattern of conductor structures on an isolating carrier board. In such photolithographic processes, photosensitive material (photoresist) is used which is exposed to light according to the desired pattern of conductor structures and then developed so that the metal layers underneath are only accessible in certain areas. Further steps comprise etching the layers underneath, removing the remaining photoresist and possibly depositing additional metal layers either by electroplating or by electroless (chemical) metal deposition. Furthermore, cleaning and activating steps may be included. Such known methods are commonly classified into subtractive and additive methods. In order to produce through-holes or blind holes, mechanical drilling with subsequent copper deposition is used.

From the document US-A-4 651 417 there is known a method for making a circuit board wherein a recessed pattern is pressed into a substrate, a conductive coating is deposed, and the coating removed outside the recesses.

More recently, lasers have also been applied in the manufacture of printed circuit boards. From EP-A-0 164 564, for example, it is known to produce blind holes in a substrate by an excimer laser. The process of removing material from a substrate is called laser ablation. EP-A-0 287 843 discloses the removal of nucleation on a carrier board, for example a palladium compound, by means of a UV laser. The removal of an etch resist layer by a Nd-YAG laser is disclosed in EP-0 469 635. From Research Disclosure RD 32646, published June 1991, a process for making a printed circuit board is known which starts from a laminate comprising a central layer containing catalyst particles which can activate an electroless plating process and a second layer which does not contain catalyst particles. The second layer is removed in certain areas and holes are created by laser ablation, and finally electroless plating is carried out to metallize the pattern and the walls of the holes.

### SUMMARY OF THE INVENTION

In view of the prior art, it is an object of the invention to provide a method of manufacturing printed circuit boards, which does not require photolithographic process steps and which does not require catalyst particles in the isolating carrier material.

It is a further object of the invention to provide a method which permits to produce printed circuits on a carrier substrate with a very high density of the conductor structures, resulting in sizes of the conductor structures in the range of and below one micrometer.

It is an additional object of the invention to provide a method of manufacturing printed circuits which allows to produce the conductor structures in a single flexible carrier substrate without requiring multiple laminated layers of substrates.

According to the present invention, these objects are achieved by a process comprising the steps of claim 1 or 12.

Relative to known manufacturing processes, the invention requires only a small number of process steps. Consequently, the usual problem of registration of the conductor structures which is particularly pronounced if a plurality of process steps have to be performed (e.g., multiple cycles of exposure, drilling) is no longer present. Furthermore, the manufacturing process of the invention is fast, cost saving, and ensures high reproducibility and quality. Another advantage is that the process starts with simple and inexpensive base material, such as a dielectric foil, whereas prior art processes require multilayer laminated materials which is expensive and often not available in constant quality. According to a further advantage, the resulting surface of the printed circuit is substantially plane and thus allows easy lamination with other printed circuits and further processing to manufacture multilayer printed circuits. The method of the invention is environmentally beneficial because it does not necessarily use wet chemistry like solvents or etchants; since it is an additive process, there are no waste products. The method of the invention allows the production of small conductor structures and a high integration density.

In an embodiment of the invention, the first step consists in producing recesses in a dielectric foil according to the desired pattern of conductor structures by laser ablation using a mask. In a second step, the desired holes are created by laser ablation also by using a mask. These holes can later be used for through-contacting or as functional openings. As an alternative, it is also possible to combine these two steps in one step, if a phase mask is used. The processed foil is cleaned by a plasma process or by cleaning in an ultrasonic bath. Then, the entire surface of the foil is metallized, for example by physical vapor deposition (PVD). The PVD layer is increased by electrochemical metal deposition or by electroplating until the final thickness of the conductor structures is achieved. Alternatively, the entire thickness of the conductor structures could be produced solely by a PVD or a similar metallization process. The foil is then processed by a grinding step to remove excess metal such that only the metallized areas in the recesses and holes, corresponding to the desired pattern, remain. Now, additional layers of dielectric material with conductor structures produced in the described way can be laminated to the processed foil, in order to produce multilayer circuits.

According to an alternative embodiment of the laser ablation process of the invention, the carrier substrate (e.g., dielectric foil) comprises a material which becomes conductive when irradiated with light. In that way, it is possible to deposit conductive material only in the recesses and holes which have before been produced by laser ablation. Thus, the step of removing excess material outside the areas of desired conductor structures is not necessary. A further advantage is that there are no waste products.

Instead of the mentioned optical mask for performing laser ablation, an adaptive optical system having a plurality of adjustable mirrors directing individual rays of the laser beam to the dielectric foil, can be used. Such an adaptive optical system has the advantage that it is very flexible because the pattern of conductor structures and holes can quickly be changed, simply by reprogramming the control of the adjustable mirrors. Furthermore, an adaptive optical system ensures a more efficient use of the energy provided by the laser and thus permits an increased throughput in the manufacturing process.

### BRIEF DESCRIPTION OF THE DRAWINGS

Subsequently, embodiments of the invention will be explained in detail with reference to he drawings.
- Figures 1a-1g: show process steps of a first embodiment of the method of the invention.
- Figures 2a-2f: show process steps of a second embodiment of the invention.
- Figures 3a-3d: show process steps of a third embodiment of the invention.
- Figure 4: schematically shows an optical system used in an embodiment of the invention.

### DETAILED DESCRIPTION OF THE INVENTION

Figures 1a-1g illustrate a first embodiment of the method of the invention. According to Figure la, the starting material is a foil 1 made of a dielectric material, for example polyimide. The thickness of the foil 1 typically ranges from about 10 to about 80 micrometers. In a first process step, illustrated in Figure 1b, recesses 2,3,4,5 are produced in the foil 1 by laser ablation using an excimer laser which is transmitted through a corresponding mask. The recesses 3,4,5 correspond to the desired conductor structures of the printed circuit board; the recess 2 is produced at a location where a through-hole 2a will be produced in the subsequent step (Figure 1c).

The depth of the recesses is controlled by controlling the total amount of laser energy incident on the foil 1. This energy can be adjusted, for example, by appropriate control of the number of laser pulses impinging on the foil or by controlling the total time during which the foil is irradiated with laser light. The recesses 2,3,4,5 typically have a depth of about 1 to 20 micrometers. In order to ensure that the laser light impinges on the foil 1 only at the locations where conductor structures and holes are to be produced, a mask corresponding to the desired pattern of conductor structures and holes is used. Thus, a pattern of lines is created in the foil 1 corresponding to the desired pattern of conductor structures.

In the next step, illustrated in Figure 1c, the desired through-holes 2a in the foil 1 are produced by laser ablation. For this purpose, the foil is irradiated again with an excimer laser at the locations where holes are to be created through a corresponding mask which is transparent for laser light only at the locations of the holes. Typical diameters of the through-holes 2a range from about 20 to about 50 micrometers.

Then, a cleaning step is performed to remove any residues from the laser ablation process, either by using an oxygen plasma or an aqueous medium.

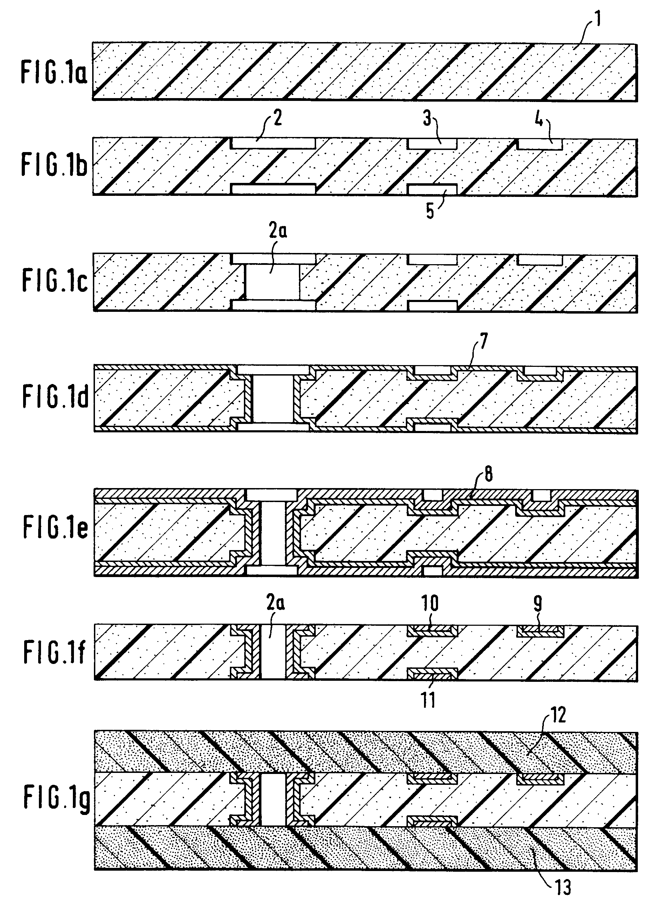

In the next step according to Figure 1d, the foil 1 is metallized on its entire surface including the recesses 3,4,5 and on the inner walls of the through-holes 2a. This metallization step uses physical vapor deposition (PVD), such as sputtering or anodic or cathodic arc evaporation. As a result of the PVD process, an approximately 200 nm thick metal layer 7 is deposited on the surface of the foil 1. Typically, the metal layer 7 comprises copper; other metals, however, such as silver, could also be used.

Thereafter, an additional metal layer 8 (preferably copper) is deposited on the PVD layer 7 either by chemical metal deposition or by a galvanic process (electroplating). According to a practical example, the thickness of the resulting layer 8 shown in Figure 1e may range from about 10 to 40 micrometers. Preferably, the thickness of the layer 8 equals the depth of the recesses 2,3,4,5. In order to improve adhesion of the PVD layer 7, an adhesive layer, such as nickel, chromium, palladium, or silver may be deposited on the dielectric substrate 1 or applied in the PVD process before deposition of the PVD layer. Alternatively, the dielectric substrate 1 can be activated in a plasma before metal deposition.

In the next step, the metal (e.g., copper) is removed from those areas on the foil 1 where no conductor structures are desired in the final printed circuit. This removal of metal outside the desired conductor structures is performed by a mechanical processing step, such as grinding, polishing, or milling. The result is shown in Figure 1f. Thus, there is only metal left in the desired conductor structures, for example 9, 10, 11 , and in the through-holes 2a. Thereafter, the foil is electrochemically polished or briefly chemically etched. This is done in order to compensate for irregularities and to ensure a sufficient safety of the process.

Then, dielectric foils 12 and 13 are laminated to the top and bottom side, respectively, of the thus produced two-layer printed circuit. The result is shown in Figure 1g. At those locations of the printed circuit which have to be electrically accessible, for example for mounting components, openings are produced in the dielectric foil. For producing such openings, a laser ablation process is performed using an appropriate mask so that the laser impinges only on those spots of the foil where openings are to be made.

For producing multi-layer printed circuits, dielectric foils are laminated to the printed circuit on both sides after the step of mechanical removal (grinding) of excess metal (Fig. 1f), and the process as described above is repeated. It is possible to create blind holes which provide access to layers underneath as well as through-holes.

In the process described above, the creation of through-holes 2a and recesses 3,4,5 is performed in two steps, as shown in Figures 1b and 1c. In an alternative thereto, one could perform the ablation in a single step. According to this embodiment, a change-over mask is used, and the foil 1 is processed by laser ablation at the locations of the recesses 3,4,5 and at the locations of the holes 2a until the recesses have the required depth. Then the mask is changed and only the holes 2a are further ablated until the desired passage through the foil 1 has been created.

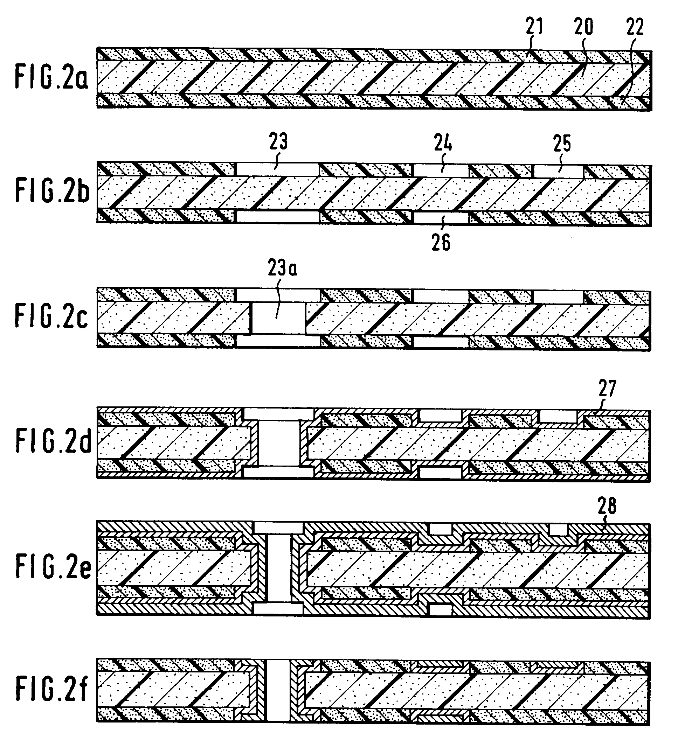

In the following, an alternative embodiment to the one described in connection with Figures 1a-1g will be described with reference to Figures 2a-2f. The process starts with a dielectric foil 20 to which dielectric foils 21 and 22 of a different material as that of the foil 20 are laminated on both sides. In the first step illustrated by Figure 2a, the desired pattern of conductor structures 24, 25, 26 as well as recesses 23 at the locations where through-holes are desired, are produced in the foils 21 and 22 by laser ablation. In the next step, illustrated in Figure 2c, the through-holes 23a are produced by laser ablation. The material of the foils 21 and 22 is preferably selected such that it can be ablated more easily than the material of the foil 20. In that way, the depth of the recesses 24, 25, 26 can be precisely controlled. The depth of the recesses is defined by the thickness of the foils 21 and 22. Then the entire surface is metallized by physical vapor deposition as shown in Figure 2d. The resulting metal layer has the reference numeral 27.

Thereafter, an additional metal layer 28 is deposited on the vapor deposited layer by electroplating. The result is shown in Figure 2e. Then, according to Figure 2f, the metallized foil is mechanically processed by grinding, polishing or milling, so that the metal (copper) only remains in the desired structures 24, 25, 26 and in the holes 23a. In the present embodiment, the laser ablation is performed with the same equipment as in the first embodiment, i.e., using a mask with a corresponding pattern of desired conductor structures and holes. The present embodiment of the invention has the advantage that lasers can be used for the ablation process which cannot be controlled as precisely as an excimer laser for producing the required depths in the dielectric material. The reason is that the depth is mainly determined by the thickness of the foil material.

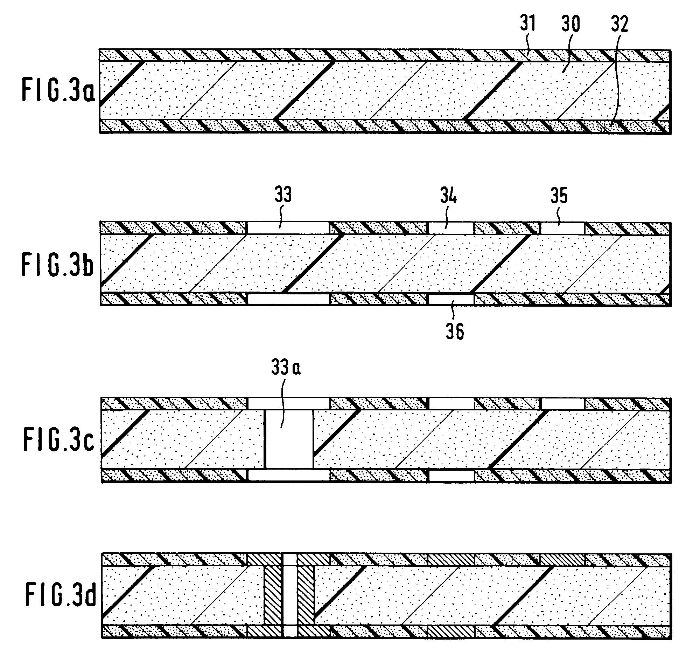

A third embodiment of the method of the invention will now be explained with reference to Figures 3a-3d. According to Figure 3a, the process starts with a dielectric foil 30 to which different dielectric foils 31 and 32 are laminated on both sides. A special feature of this embodiment is that the foil 30 comprises a substance which, when irradiated by laser light, becomes electrically conductive. Examples of such materials which show laser-induced electrical conductivity are organic polymers of poly (bis ethylthio-acetylene) and poly (bis alkylthio acetylene). Materials of the mentioned type are described in: R. Baumann et al.: "Local Electrical Conductivity in Poly (Bis-Alkylthio-Acetylene) Layers After Laser Irradiation", Synthetic Metals (1993), Pages 3643-3648. The dielectric foils 31 and 32 do not have the mentioned characteristics of the foil 30.

In a first step, illustrated in Figure 3b, the pattern of desired conductor structures 34, 35, 36 as well as recesses 33 at the locations where through-holes are desired, are produced in the laminated foils 31 and 32 by laser ablation. At the same time, the material in the foil 30 is activated by the laser radiation so that it becomes electrically conductive. In the next step, according to Figure 3c, through-holes 33a are produced by laser ablation. Then a step of electroless plating is performed to fill the structures 34, 35, 36 with metal (e.g., copper). The result is shown in Figure 3d. One of the advantages of this embodiment is that no removal of excess material is required: The metal is only growing at the locations 34, 35, 36 which have been irradiated by the laser. Furthermore, no waste products are produced, making the method environmentally beneficial. As an alternative to the electroless plating, the copper can also be applied by electroplating, provided all structures, such as structures 34, 35, 36 are connected via a contact line for plating.

It is understood that all the above described processes can, merely by repeating the described process steps, also be used for producing multi-layer printed circuit boards.

In an embodiment of the invention, the mask used for the laser ablation of the desired structures in the dielectric foil may be, for example, a phase mask. Such a phase mask comprises a quartz substrate on which dielectric layers are applied. At those locations of the mask which correspond to holes in the printed circuit, the dielectric layers are completely removed, and at those locations which correspond to recesses in the foil, only some of the dielectric layers are removed. Such a phase mask has the advantage that the creation of holes and recesses for conductor structures can be performed in a single process step. As an alternative thereto, the laser ablation could be performed without a mask, either by directly "writing" on the foil with the laser beam or by the use of an adaptive optical system. The direct writing on the foil is accomplished either by deflecting the laser beam using, for example, a system of mirrors or refractive elements, or by moving the foil relative to the stationary beam.

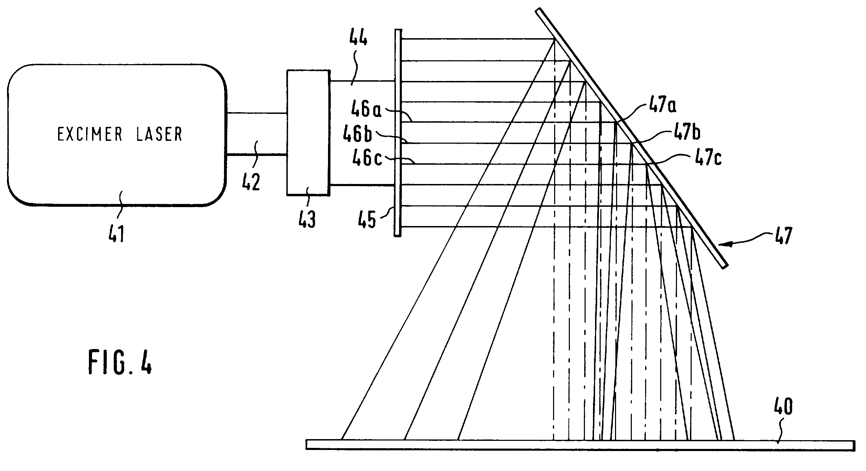

The mentioned adaptive optical system will now be described with reference to Figure 4. The substrate, e.g., foil, which is to be processed by laser ablation is denoted with reference numeral 40. The laser beam 42 emitted by an excimer laser 41 is transformed by a homogenizer 43 to a wide, spatially homogeneous beam 44. The beam 44 impinges on a two-dimensional array 45 of microlenses. The microlens array 45 is manufactured from a single plate and comprises several thousand individual lenses (typically about ten thousand). According to a practical example, the lenses have an outer diameter of about 100 micrometers, respectively. The microlens array 45 produces from the incident beam 44 a plurality of individual beams, such as beams 46a, 46b, 46c. Each of these individual beams impinges on a corresponding mirror element 47a, 47b, 47c, respectively, of an adaptive reflector 47. The mirror elements of the adaptive reflector 47 can be individually adjusted by means of piezoelectric drives, respectively. By corresponding control of the mirror elements, the beams from the microlens array are directed to the desired locations on the substrate 40. Thus the desired pattern of recesses and holes in the foil is created by laser ablation. By appropriate control of the energy density of the radiation, holes and conductor structures can be produced simultaneously. The mirror elements of the adaptive reflector 47 can be moved by their associated piezoelectric drives during the laser irradiation in order to produce the desired pattern of conductor structures. As an alternative to the mentioned piezoelectric drive of the mirror elements, a galvanometer drive could also be used.

It is understood that the adaptive optical system explained in connection with Figure 4 can be used as an optical system for laser ablation with any of the before described embodiments of the process of the invention.

The material of the dielectric substrate (e.g., foil) is, for example, polyimide, but other materials can also be used, such as epoxy resin, cyanate ester, polyester, polyphenylsulfide, polytetrafluorethylene, bismaleimid-triazine. The foil can be processed in the form of individual cut sheets or from a reel on which the plastic material is wound. Even though the dielectric substrate in a preferred embodiment of the invention is a thin foil, the invention is not limited thereto, but other forms of dielectric material can also be used, for example a dielectric carrier board.

## Claims

1. A method of manufacturing printed circuit boards, comprising the following steps:
a) producing by laser ablation recesses and/or holes in a carrier substrate of isolating material which has a thickness below about 80 micrometers, said recesses corresponding to a desired pattern of conductor structures and/or holes.
b) deposition of metal by physical vapour deposition on substantially the entire surface of the substrate, and
c) removing conductive material from the substrate outside the desired pattern of conductor structures and/or holes.

2. Method as in claim 1, wherein the laser ablation (step a) comprises irradiating the substrate by an excimer laser (41) for a time sufficient to produce a predetermined depth of the recesses (3,4,5).

3. Method as in claim 1 or 2, wherein the deposition of conductive material on the substrate (step b) ) comprises physical vapor deposition.

4. Method as in any of the claims 1 to 3, wherein after step b) and before step c) the following step b2) is performed:
b2) depositing conductive material on the metal layer produced by step b).

5. Method as in claim 4, wherein step b2) comprises a step of electroplating.

6. Method as in any of the preceding claims, wherein the step of removing conductive material from the substrate (step c)) comprises a step of grinding the surface of the substrate.

7. Method as in any of the preceding claims, wherein the carrier substrate is a dielectric foil.

8. Method as in claim 1, wherein the carrier substrate comprises at least two dielectric foils (20,21) of different materials laminated to each other and wherein the recesses are produced substantially only in one of the two foils.

9. Method as in any of the preceding claims wherein step b) comprises a step of sputtering.

10. Method as in any of the preceding claims, wherein step a) comprises transmitting a laser beam through a mask corresponding to the desired pattern of conductor structures and/or holes.

11. Method as in any of the claims 1 to 10, wherein step a) comprises transmitting a laser beam through an adaptive optical system having a plurality of adjustable reflecting elements (47a, 47b, 47c) for directing individual rays of the laser beam to the substrate (40).

12. A method of manufacturing printed circuit boards, comprising the following steps:
a) producing by laser ablation recesses and/or holes in a carrier substrate of isolating material, said recesses corresponding to a desired pattern of conductor structures and/or holes, wherein the carrier substrate comprises a material which becomes conductive when irradiated with light;
b) deposition of conductive material only in the recesses and/or holes produced in step a). .

## Patentansprüche

1. Verfahren zur Herstellung von Leiterplatten, welches folgende Schritte umfaßt:
a) Erzeugen von Vertiefungen und/oder Löchern in einem Trägersubstrat aus isolierendem Material, welches eine Dicke von weniger als etwa 80 Mikrometer aufweist, durch Laserablation, wobei die Vertiefungen einem gewünschten Muster an Leiterstrukturen und/oder Löchern entsprechen,
b) Ablagern von Metall durch das PVD-Verfahren auf im wesentlichen der ganzen Oberfläche des Substrats und
c) Entfernen von leiffähigem Material von dem Substrat außerhalb des gewünschten Musters an Leiterstrukturen und/oder Löchern.

2. Verfahren gemäß Anspruch 1, wobei die Laserablation (Schritt a) das Bestrahlen des Substrats durch einen Excimerlaser (41) für eine ausreichende Zeit umfaßt, um eine vorgegebene Tiefe der Vertiefungen (3, 4, 5) zu erzeugen.

3. Verfahren gemäß Anspruch 1 oder 2, worin das Ablagern des leiffähigen Materials auf dem Substrat (Schritt b) das PVD-Verfahren umfaßt.

4. Verfahren gemäß einem der Ansprüche 1 bis 3, worin nach Schritt b) und vor Schritt c) der folgende Schritt b2) durchgeführt wird:
b2) Ablagem von leiffähigem Material auf der durch Schritt b) erzeugten Metallschicht.

5. Verfahren gemäß Anspruch 4, worin der Schritt b2) einen Schritt des Galvanisierens umfaßt.

6. Verfahren gemäß einem der vorangehenden Ansprüche, worin der Schritt der Entfernung des leiffähigen Materials von dem Substrat (Schritt c) einen Schritt des Schleifens der Oberfläche des Substrats umfaßt.

7. Verfahren gemäß einem der vorangehenden Ansprüche, worin das Trägersubstrat eine dielektrische Folie ist.

8. Verfahren gemäß Anspruch 1, worin das Trägersubstrat mindestens zwei dielektrische Folien (20, 21) verschiedener Materialien umfaßt, die zusammenlaminiert sind, und worin die Vertiefungen im wesentlichen nur in einer der beiden Folien erzeugt werden.

9. Verfahren gemäß einem der vorangehenden Ansprüche, worin Schritt b) einen Schritt des Sprühens umfaßt.

10. Verfahren gemäß einem der vorangehenden Ansprüche, worin Schritt a) das Senden eines Lasterstrahls durch eine Maske, die dem gewünschten Muster an Leiterstrukturen und/oder Löchern entspricht, umfaßt.

11. Verfahren gemäß einem der vorangehenden Ansprüche 1 bis 10, worin Schritt a) das Senden eines Laserstrahls durch ein adaptives optisches System umfaßt, das eine Vielzahl an einstellbaren reflektierenden Elementen (47a, 47b, 47c) zum Leiten der einzelnen Strahlen des Laserstrahls zum Substrat (40) aufweist.

12. Verfahren zur Herstellung von Leiterplatten, welches folgende Schritte umfaßt:
a) Erzeugen von Vertiefungen und/oder Löchern in einem Trägersubstrat aus isolierendem Material, wobei die Vertiefungen einem gewünschten Muster an Leiterstrukturen und/oder Löchern entspricht, worin das Trägersubstrat ein Material, das unter Bestrahlung mit Licht leitend wird, umfaßt,
b) Ablagern von leiffähigem Material nur in den Vertiefungen und/oder Löchern, die in Schritt a) erzeugt wurden.

## Revendications

1. Procédé de fabrication de plaques de circuits imprimés, comprenant les étapes suivantes consistant à :
a) produire des évidements et/ou des trous par ablation au laser dans un substrat support en matériau isolant qui a une épaisseur inférieure à environ 80 micromètres, lesdits évidements correspondant à un schéma souhaité de structure de conducteurs et/ou de trous.
b) déposer du métal par dépôt physique en phase vapeur sur essentiellement l'ensemble de la surface du substrat, et
c) retirer le matériau conducteur du substrat à l'extérieur du schéma souhaité de structure de conducteurs et/ou de trous.

2. Procédé selon la revendication 1, dans lequel l'ablation au laser (étape a) comprend l'irradiation du substrat par un laser à excimère (41) pendant un temps suffisant pour produire des évidements d'une profondeur prédéterminée (3, 4, 5).

3. Procédé selon la revendication 1 ou 2, dans lequel le dépôt du matériau conducteur sur le substrat (étape b)) comprend le dépôt physique en phase vapeur.

4. Procédé selon l'une quelconque des revendications 1 à 3, dans lequel après l'étape b) et avant l'étape c) on réalise l'étape suivante b2) :
b2) déposer du matériau conducteur sur la couche métallique produite par l'étape b).

5. Procédé selon la revendication 4, dans lequel l'étape b2) comprend une étape d'électrodéposition.

6. Procédé selon l'une quelconque des revendications précédentes, dans lequel l'étape consistant à retirer le matériau conducteur du substrat (étape c)) comprend une étape de ponçage de la surface du substrat.

7. Procédé selon l'une quelconque des revendications précédentes, dans lequel le substrat support est une feuille de diélectrique.

8. Procédé selon la revendication 1, dans lequel le substrat support comprend au moins deux feuilles de diélectrique (20, 21) de matériaux différents laminés l'un à l'autre et dans lequel les évidements sont produits essentiellement seulement dans l'une des deux feuilles.

9. Procédé selon l'une quelconque des revendications précédentes dans lequel l'étape b) comprend une étape de pulvérisation cathodique.

10. Procédé selon l'une quelconque des revendications précédentes dans lequel l'étape a) comprend la transmission d'un faisceau laser à travers un masque correspondant au schéma souhaité de structure des conducteurs et/ou des trous.

11. Procédé selon l'une quelconque des revendications 1 à 10, dans lequel l'étape a) comprend la transmission d'un faisceau laser à travers un système optique adaptable ayant un grand nombre d'éléments réfléchissants ajustables (47a, 47b, 47c) pour diriger des rayons individuels du faisceau laser sur le substrat (40).

12. Procédé de fabrication de plaques de circuits imprimés, comprenant les étapes suivantes consistant à :
a) produire des évidements et/ou des trous par ablation au laser dans un substrat support en matériau isolant, lesdits évidements correspondant à un schéma souhaité de structure de conducteurs et/ou de trous, dans lequel le substrat support comprend un matériau qui devient conducteur lorsqu'il est irradié avec de la lumière.
b) déposer du matériau conducteur seulement dans les évidements et/ou les trous produits à l'étape a).
